Europäisches Patentamt

European Patent Office

Office européen des brevets

(11) Publication number: **0 096 109**
**B1**

# EUROPEAN PATENT SPECIFICATION

(45) Date of publication of patent specification: **15.06.88**

(21) Application number: **82109564.3**

(22) Date of filing: **15.10.82**

(51) Int. Cl.⁴: **G 06 F 11/10,** G 11 B 5/09 //
H03M13/00

(54) Error correcting system.

(30) Priority: **15.06.82 JP 102816/82**

(43) Date of publication of application:
**21.12.83 Bulletin 83/51**

(45) Publication of the grant of the patent:
**15.06.88 Bulletin 88/24**

(84) Designated Contracting States:
**DE FR GB NL**

(56) References cited:
EP-A-0 032 055
EP-A-0 061 345
GB-A-2 079 993
US-A-3 418 629
US-A-3 668 632
US-A-3 781 791
US-A-4 099 160

1980 INTERNATIONAL ZURICH SEMINAR ON
DIGITAL COMMUNICATIONS, 4th-6th March
1980, Zurich, Proceedings, IEEE Catalog no.
80CH1521-4 COM, pages G4.1-G4.5, IEEE, New
York, US; P. STAMMNITZ: "Error protection of
34 MBit/s DPCM encoded TV signals with
multiple error correcting BCH codes"

(73) Proprietor: **KABUSHIKI KAISHA TOSHIBA**
**72, Horikawa-cho Saiwai-ku**
**Kawasaki-shi Kanagawa-ken 210 (JP)**

(72) Inventor: **Nagumo, Masahide**
**38 Ogura Saiwai-ku**
**Kawasaki-shi (JP)**
Inventor: **Inagawa, June**
**9-4-3, Konandai Konan-ku**
**Yokohama-shi (JP)**
Inventor: **Kojima, Tadashi**
**6-20-49, Kugo-cho**
**Yokosuka-shi Kanagawa-ken (JP)**

(74) Representative: **Blumbach Weser Bergen**
**Kramer Zwirner Hoffmann Patentanwälte**
**Radeckestrasse 43**
**D-8000 München 60 (DE)**

(56) References cited:
IBM TECHNICAL DISCLOSURE BULLETIN, vol.
21, no. 7, December 1978, pages 2937-2942,
New York, US; C.L. CHEN: "High-speed
decoding of BCH codes"

IBM JOURNAL OF RESEARCH AND
DEVELOPMENT, vol. 23, no. 3, May 1979, pages
299-315, New York, US; R.E. BLAHUT:
"Transform techniques for error control codes"

Note: Within nine months from the publication of the mention of the grant of the European patent, any person may
give notice to the European Patent Office of opposition to the European patent granted. Notice of opposition shall
be filed in a written reasoned statement. It shall not be deemed to have been filed until the opposition fee has been
paid. (Art. 99(1) European patent convention).

EP 0 096 109 B1

## Description

The present invention relates to an error correcting system which is improved so as to be effectively used in combination with, for example, a digital audio disk (DAD) device using a compact disk (CD).

Various optical DAD devices have been developed recently. As well known, in an optical DAD device using a compact disk, cross interleaved Reed-Solomon codes (CIRC) are used as error correction codes. A cross interleaved Reed-Solomon code is obtained by submitting to a signal process called "cross interleaving" a Reed-Solomon code, a kind of BCH code, which is generally regarded as the most effective random error correction code hitherto known. The cross interleaved Reed-Solomon code thus obtained can correct even a burst error.

A Reed-Solomon code can be decoded in the same way as is a BCH code, thereby performing an error correction.

A Reed-Solomon code consisting of k data symbols and (n-k) inspection symbols, i.e. a code consisting of n symbols, is decoded in the following manner. Here, n symbols are the 2m elements of a finite field called "Galois field GF($2^m$)" which represents m binary bits. The generator polynomial $g_{(x)}$ representing a Reed-Solomon code used to correct t errors is given by the following equation (1) or (2), where a is the origin element Galois field GF ($2^m$):

$$g_{(x)}=(x+a)(x+a^2),\ldots(x+a^{2t}) \qquad (1)$$

$$g_{(x)}=(x+a^0)(x+a),\ldots(x+a^{2t-1}) \qquad (2)$$

Let $C_{(x)}$, $R_{(x)}$ and $E_{(x)}$ denote a transmitted code word, a received code word and an error polynomial, then:

$$R_{(x)}=C_{(x)}+E_{(x)} \qquad (3)$$

The coefficients contained in polynomial $E_{(x)}$ are also contained in Galois field GF($2^m$). Hence, error polynomial $E_{(x)}$ contains only terms which correspond to error locations and the value (i.e. size) of error.

Let Xj denote an error location, and let $Y_j$ denote the value of the error at location Xj, error polynomial $E_{(x)}$ is then given:

$$E_{(x)}=\sum_j Y_j Xj \qquad (4)$$

where $\Sigma$ is the sum of errors at all error locations.

Here, syndrome $S_i$ is put:

$$Si=R(a^i) \ [i=0, 1, \ldots 2t-1] \qquad (5)$$

Then, from equation (3):

$$Si=C(a^i)+E(a^i).$$

Both $C_{(x)}$ and $g_{(x)}$ can be divided, leaving no remainder. The following therefore holds true:

$$S_i=E(a^i).$$

From equation (4) it is evident that syndrome $S_i$ may be expressed as follows:

$$S_i=E(a^i)=\sum_j Y_j(aj)i=\sum_j Y_j X_j^i \qquad (6)$$

where $aj=X_j$ and $X_j$ represents the error location for aj.

Error location polynomial $\sigma_{(x)}$ is given by:

$$\sigma_{(x)}=\pi_i(x-X_i)$$

$$=x^e+\sigma_1 x^{e-1}+\ldots+\sigma_e \qquad (7)$$

where e is the number of the errors.

$\sigma_1$ to $\sigma_e$ in equation (7) are related to syndrome $S_i$ as shown below:

$$S_{i+e}+\sigma_1 S_{i+e-1}+\ldots\sigma_{e-1}S_{i+1}+\sigma_e S_i=0 \qquad (8)$$

To sum up the above, such a Reed-Solomon code as defined above is decoded in the following steps:

(I) Calculate syndrome $S_i$ [equation (5)].
(II) Obtain coefficients $\sigma_1$ to $\sigma_e$ contained in error location polynomial $\sigma_{(x)}$ [equation (8)].
(III) Find the root $X_j$ of error location polynomial $\sigma_{(x)}$ [equation (7)].
(IV) Find error value $Y_j$ [equation (6)], and calculate error polynomial [equation (4)].
(V) Correct error [equation (3)].

Now it will be described how to decode, in the above-mentioned steps, a Reed-Solomon code consisting of many blocks data each containing four inspection symbols. This code is represented by the following generator polynomial $g_{(x)}$:

$$g(x) = (x+1)(x+\alpha)(x+\alpha^2)(x+\alpha^3).$$

In this case, two errors can be corrected. The Reed-Solomon code may be decoded in the following method A or the following method B.

[Method A]
(I) Find syndromes $S_0$ to $S_3$.
(II) Rewrite equation (8) for $e=1$ and $e=2$.

In the case of $e=1$:

$$\left. \begin{array}{l} S_1 + \sigma_1\ S_0 = 0 \\ S_2 + \sigma_1\ S_1 = 0 \\ S_3 + \sigma_1\ S_2 = 0 \end{array} \right\} \tag{9}$$

In the case of $e=2$:

$$\left. \begin{array}{l} S_2 + \sigma_1\ S_1 + \sigma_2\ S_0 = 0 \\ S_3 + \sigma_1\ S_2 + \sigma_2\ S_1 = 0 \end{array} \right\} \tag{10}$$

Assume that the decoder used starts functioning with the case of $e=1$. Solution $\sigma_1$ must then be given which satisfies simultaneous equations (9). If no solution $\sigma_1$ is found, the decoder must find solutions $\sigma_1$ and $\sigma_2$ which satisfy simultaneous equations (10). If no solution $\sigma_1$ or $\sigma_2$ is found still, then: $e \geq 3$. Solution $\sigma_1$ of equations (9) is:

$$\sigma_1 = \frac{S_1}{S_0} = \frac{S_2}{S_1} = \frac{S_3}{S_2}$$

Solutions $\sigma_1$ and $\sigma_2$ of equations (10) are:

$$\sigma_1 = \frac{S_0\ S_3 + S_1\ S_2}{S_1^2 + S_0\ S_2}, \qquad \sigma_2 = \frac{S_1\ S_3 + S_2^2}{S_1^2 + S_0\ S_2}.$$

(III) If coefficient $\sigma_1$ in the error location polynomial is obtained, find the root of the error location polynomial [equation (7)].

In the case of $e=1$:

$$\sigma_{(x)} = x + \sigma_1 = 0. \text{ Therefore, } X_1 = \sigma_1.$$

In the case of $e=2$:

$$\sigma_{(x)} = x^2 + \sigma_1 x + \sigma_2 = 0 \tag{11}$$

Substituting the elements of Galois field $GF(2^m)$ in equation (11) one after another will yield roots $X_1$ and $X_2$.

(IV) If roots of the error location polynomial are found, determine error value $Y_j$ [equation (6)].

In the case of $e=1$:

$$S_0 = Y_1. \text{ Therefore, } Y_1 = S_0.$$

In the case of $e=2$:

$$\left.\begin{array}{l} S_0 = Y_1 + Y_2 \\ S_1 = Y_1\,X_1 + Y_2\,X_2 \end{array}\right\}$$

Therefore:

$$Y_1 = \frac{X_2\,S_0 + S_1}{X_1 + X_2}$$

$$Y_2 = S_0 + Y_1.$$

(V) Correct error, using correction values $Y_1$ and $Y_2$ thus obtained.

If the value of an error location is correctly found by pointer erasure method, the Reed-Solomon code used to correct an error twice can be used to correct four errors in the following method B.

[Method B]

(I) Find syndromes $S_0$ to $S_3$.

(II), (III) Find the error location in different methods.

(IV) Find the error value [equation (6)].

In the case of $e=1$:

Same as in Method A.

In the case of $e=2$:

Same as in Method A.

In the case of $e=3$:

$$\left.\begin{array}{l} S_0 = Y_1 + Y_2 + Y_3 \\ S_1 = Y_1\,X_1 + Y_2\,X_2 + Y_3\,X_3 \\ S_2 = Y_1\,X_1{}^2 + Y_2\,X_2{}^2 + Y_3\,X_3{}^2 \end{array}\right\}$$

Solve these simultaneous equations, thus finding $Y_1$, $Y_2$ and $Y_3$:

$$Y_1 = \frac{(S_2 + X_3\,S_1) + X_2\,(S_1 + X_3\,S_0)}{(X_1 + X_2)(X_1 + X_3)}$$

$$Y_2 = \frac{(S_1 + X_3\,S_0) + Y_1(X_1 + X_3)}{(X_2 + X_3)}$$

$$Y_3 = S_0 + Y_1 + Y_2.$$

In the case of $e=4$:

$$\left.\begin{array}{l} S_0 = Y_1 + Y_2 + Y_3 + Y_4 \\ S_1 = Y_1\,X_1 + Y_2\,X_2 + Y_3\,X_3 + Y_4\,X_4 \\ S_2 = Y_1\,X_1{}^2 + Y_2\,X_2{}^2 + Y_3\,X_3{}^2 + Y_4\,X_4{}^2 \\ S_3 = Y_1\,X_1{}^3 + Y_2\,X_2{}^3 + Y_3\,X_3{}^3 + Y_4\,X_4{}^3 \end{array}\right\}$$

Solve these simultaneous equations, thus finding $Y_1$, $Y_2$, $Y_3$ and $Y_4$:

$$Y_1 = \frac{\{(S_0 X_4 S_1)X3 + (S_1 X_4 + S_2)\}X_2 + (S_1 X_4 + S_2)X_3 + (S_2 X_4 + S_2)}{(X_1 + X_2)(X_1 + X_3)(X_1 + X_4)}$$

$$Y_2 = \frac{(S_0 X_4 + S_1)S_3 + (S_1 X_4 + S_2) + Y_1(X_1 + X_3)(X_1 + X_4)}{(X_2 + X_3)(X_2 + X_4)}$$

$$Y_3 = \frac{(S_0 X_4 + S_1) + Y_1(X_1 + X_4) + Y_2(X_2 + X_4)}{(X_3 + X_4)}$$

$$Y_4 = S_0 + Y_1 + Y_2 + Y_3.$$

(V) Correct error, using correction values $Y_1$, $Y_2$, $Y_3$ and $Y_4$ thus obtained.

4

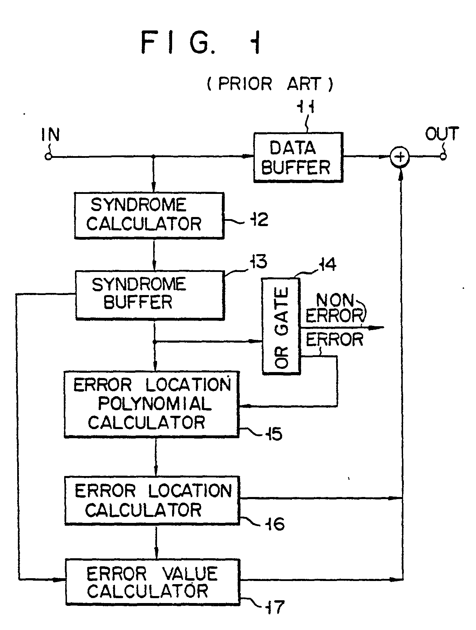

Fig. 1 is a block diagram of a known data correcting system which is designed to decode Reed-Solomon codes in the manner described above. A data to be corrected is supplied through an input terminal IN and will be corrected by a Reed-Solomon code. The data is stored into a data buffer 11 and kept stored there until a code decoding (later described) is completed. The data is supplied also to a syndrome calculator 12. From the input data the calculator 12 calculates a syndrome. The syndrome is stored into a syndrome buffer 13.

An OR gate is coupled to the output of the syndrome buffer 13. It generates an output signal which indicates whether or not an error exists on the syndrome supplied from the syndrome buffer 13. An output signal from the OR gate is supplied to an error location polynomial calculator 15. Upon receipt of the signal the calculator 15 finds the coefficients included in an error location polynominal $\sigma_{(x)}$. Data representing the coefficients are fed to an error location calculator 16. The error location calculator 16 then finds the root or roots of the error location. Data representing the root or roots are supplied from the calculator 16 to an error value calculator 17. From the input data the calculator 17 calculates an error value. The data representing the root or roots and the data representing the error value are used to correct the data from the data buffer 11.

The calculators 12, 15, 16 and 17 of the data correcting system can detect elements which are "0" and can perform algebraic operations such as addition, multiplication or division. Of these calculators, the error location polynomial calculator 15 may have such a structure as is shown in Fig. 2 and disclosed in U.S. Patent No. 4,142,174.

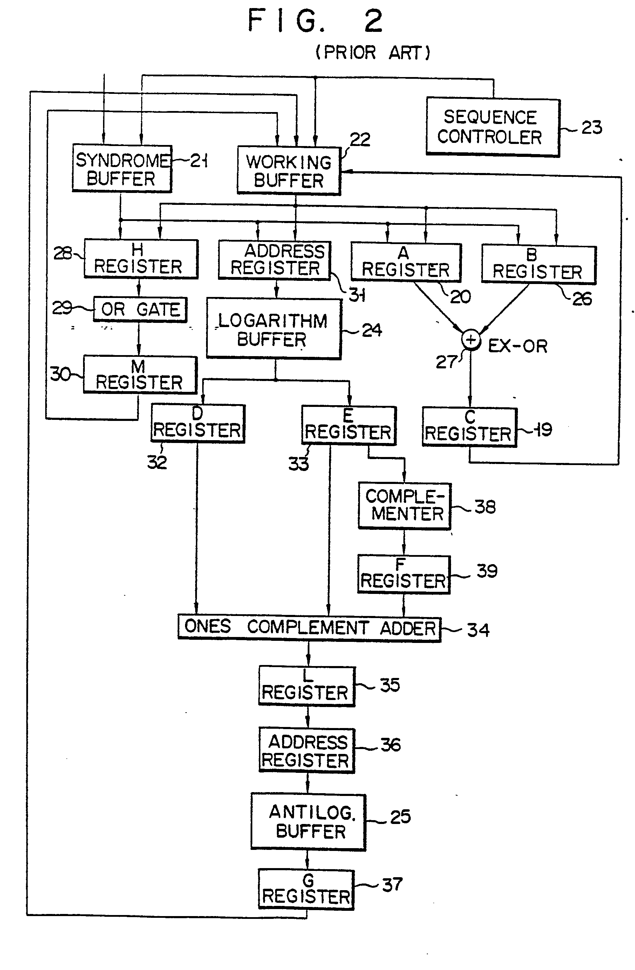

As shown in Fig. 2, the error location polynomial calculator 16 comprises a syndrome buffer 21, a working buffer 22, a sequence controller 23, a logarithm buffer 24 and an antilogarithm buffer 25. The syndrome buffer 21 is a random-access memory (RAM) for storing a syndrome Si which is an m-bit data and which represents each element of a Galois field $GF(2^m)$. The working buffer 22 is a RAM for storing an interim result of an algebraic operation performed in finding the coefficients of the error location polynomial and for storing the final result of the algebraic operation. The working buffer 22 may store partial results that will be used in algebraic operations following the algebraic operator for calculating the coefficients of the error location polynominal. The sequence controller 23 defines the order in which algebraic operations will be performed. It supplies address signals to the syndrome buffer 21 and the working buffer 22, to thereby designating desired memory locations of these buffers 21 and 22 and to check and branch the results of algebraic operations so that the results may be used in next algegraic operations. The logarithm buffer 24 is a ROM (read-only memory) storing a table of the logarithms of the elements of Galois field $GF(2^m)$. The antilogarithm buffer 25 is also a ROM storing a table of the antilogarithms of the elements of Galois field $GF(2^m)$.

The address of the logarithm buffer 24 is a binary code of element $\alpha^i$. Its entry is the logarithm of $\alpha^i$ to the base $\alpha$ that is, i. The entry at address i of the antilogarithm buffer 25 is a binary code of $\alpha^i$. Suppose the modulus polynomial $F_{(x)}$ of Galois field $GF(2^8)$ is given by:

$$F_{(x)} = x^8 + x^6 + x^5 + x^4 + 1$$

Then, the element of Galois field $GF(2^m)$ other than element 0 can be represented by a linear combination of powers to root $\alpha$ of $F_{(x)} = 0$, or $\alpha^0$—$\alpha^7$, which is expressed as follows:

$$\sum_{i=0}^{7} a_i \alpha^i \quad (a_i = 0 \text{ or } 1).$$

In this case, eight coefficients $a^0$ to $a^7$ may be taken and can be represented as binary vectors. For example, they can be given by:

$$\alpha^1 = 0 \cdot \alpha^0 + 1 \cdot \alpha^1 + 0 \cdot \alpha^2 + 0 \cdot \alpha^3 + 0 \cdot \alpha^4 + 0 \cdot \alpha^5 + 0 \cdot \alpha^6 + 0 \cdot \alpha^7$$
$$= (01000000)$$

$$\alpha^7 = 0 \cdot \alpha^0 + \ldots + 0 \cdot \alpha^6 + 1 \cdot \alpha^7$$
$$= (00000001)$$

$$\alpha^8 = 1 + \alpha^4 + \alpha^5 + \alpha^6$$
$$= (10001110)$$

$$\alpha^9 = \alpha \cdot \alpha^8 = \alpha + \alpha^5 + \alpha^6 + \alpha^7$$
$$= (01000111).$$

The elements of Galois field $GF(2^8)$ other than these can be represented as binary vectors.

The addresses (1—255) of the logarithm table are 8-bit binary vectors of elements $\alpha^i$. Entries corresponding to the addresses are binary notation of exponent i. In the antilogarithm table, exponent i is used as an address, and entries are binary vectors of $\alpha^i$.

5

Now it will be described how the error location polynomial calculator shown in Fig. 2 performs algebraic operations.

**(1) Addition**

In order to add element $\alpha^i$ and element $\alpha^j$, the former is supplied from A register 20 to an exclusive OR gate 27 and the latter is supplied from B register 26 to the exclusive OR gate 27. An exclusive logic sum of each bit of element $\alpha^i$ and the corresponding bit of element $\alpha^j$ is thus produced. The sum of elements $\alpha^i$ and $\alpha^j$ obtained by the exclusive OR gate 27 is transferred through C register 19 to the working buffer 22.

**(2) Detection of element "0"**

In order to detect whether or not element $\alpha^i$ is "0", the element is supplied from H register 28 to an OR gate 29, which produces a logic sum. The logic sum is transferred via M register 30 to the working buffer 22. The contents of M register 30 are "0" only when element $\alpha^i$ is "0".

**(3) Multiplication**

In order to multiply element $\alpha^i$ by element $\alpha^j$, it is first detected whether or not these elements are "0". If at least one of these elements is "0", it is learned that the product will be "0", without performing the multiplication. If neither is "0", these elements are loaded into an address register 31 which is connected to the logarithm buffer 24. Outputs i and j from the logarithm buffer 24 are supplied to a ones complement adder 34 through D register 32 and E register 33, respectively. The ones complement adder 34 performs addition of a complement to 1, using $2^8-1$ as modulo. The result of this addition, $(i+j)=t \bmod (2^8-1)$ is loaded through L register 35 into an address register 36 which is connected to the antilogarithm buffer 25. If the address input of the antilogarithm buffer 25 is t, the antilogarithm buffer 25 supplies an output $\alpha^t$. The output $\alpha^t$ is the product of elements $\alpha^i$ and $\alpha^j$ and is transferred to the working buffer 22 through G register 37.

**(4) Division**

In order to divide element $\alpha^i$ by element $\alpha^j$ to obtain a quotient $\alpha^i/\alpha^j$, a method similar to the above-mentioned multiplication is used, but the contents of E register 33 are subtracted from the contents of D register 32. More specifically, the logarithm of element $\alpha^j$ stored in E register 33 is complemented by a complementer 38. The output data of the complementer 38 is supplied to the complement adder 34 through F register 39. Thereafter, the data is processed in the same way as in multiplying element $\alpha^i$ by element $\alpha^j$. In this case, the output from the antilogarithm buffer 25 is the quotient, i.e. the result of the division.

The error location polynomial calculator of the known error correcting system must be provided with a logarithm buffer and an antilogarithm buffer. Without the logarithm buffer and the antilogarithm buffer, the error location polynomial calculator could not perform multiplication or division. Both buffers, which are ROMs, need to have an enormously large memory capacity. This makes it difficult to manufacture the error location polynomial calculator in the form of LSI. If the calculator may be made into LSI, the logarithm buffer and the antilogarithm buffer are excluded from the calculator. In this case, the buffers of a large memory capacity have to be connected to the calculator.

If one symbol consists of eight bits and each buffer stores 255 symbols, the buffer must have a memory capacity of 2040 bits ($=255\times8$). In this case, the known error location polynomial calculator is provided with two ROMs the total memory capacity of which amounts to 4080 bits, one ROM storing a table of logarithms and the other ROM storing a table of antilogarithm. Its error location polynomial calculator having two ROMs of a large memory capacity, the error correcting system is inevitably complicated and is thus expensive.

Document US—A—3,418,629 discloses an error correction system capable of correcting an error in a binary digit sequence. The correction is performed by detecting an error location. Since the sequence includes binary values "1" and "0" only, the correction can be immediately performed by inverting an error location.

An example is shown, where two errors are corrected using only multiplication and addition on elements of a Galois field.

It is an object of the present invention to provide an error correcting system which can perform algebraic operations such as multiplication and division on the elements of Galois field thereby to find error locations or error patterns, without using a logarithm buffer or an antilogarithm buffer of a large memory capacity and which has therefore a simple structure and is rather inexpensive.

Another object of the invention is to provide an error correction system which perform algebraic operations in a short time.

These objects are achieved with an error correcting system as claimed.

The error correcting system generates error locations and error patterns necessary for correcting error data, using an error location polynomial which is defined by double correction BCH codes each consisting of the elements of Galois field $GF(2^m)$. The system has a first data processing means and a second data processing means. The first data processing means performs only additions and multiplications thereby to solve the error location polynominal and thus generate error locations. The second data processing means performs only multiplications and additions on the data obtained by the first data processing means, thereby to generate error patterns. Only additions and multiplications are performed in the error correcting system, because adders and multipliers for adding and multiplying the elements of Galois field are relatively simple in structure. In particular, the hardware of the system is so designed as to obtain error patterns merely by multiplying the elements of Galois field. Therefore, the system need not be provided with memories of a large memory capacity, has a simple structure and is inexpensive. Further, the system can process data at a high speed.

This invention can be more fully understood from the following detailed description when taken in conjunction with the accompanying drawings, in which:

Fig. 1 is a block diagram of a known error data correcting system;

Fig. 2 is a block diagram of an error location polynominal calculator used in the system shown in Fig. 1;

Fig. 3 is a block diagram of a DAD device to which the present invention is applied;

Fig. 4 is a block diagram of the main part of an error data correcting system according to the invention;

Fig. 5 is a timing chart illustrating the operation of the system shown in Fig. 5;

Fig. 6 is a block diagram of a multiplier used in the operation unit of the system shown in Fig. 4;

Fig. 7 is a timing chart illustrating the operation of the multiplier shown in Fig. 6;

Fig. 8 is a circuit diagram of an $\alpha$ multiplier circuit used in the multiplier shown in Fig. 6; and

Fig. 9 is a circuit diagram of a $\alpha^2$ multiplier circuit used in the multiplier shown in Fig. 6.

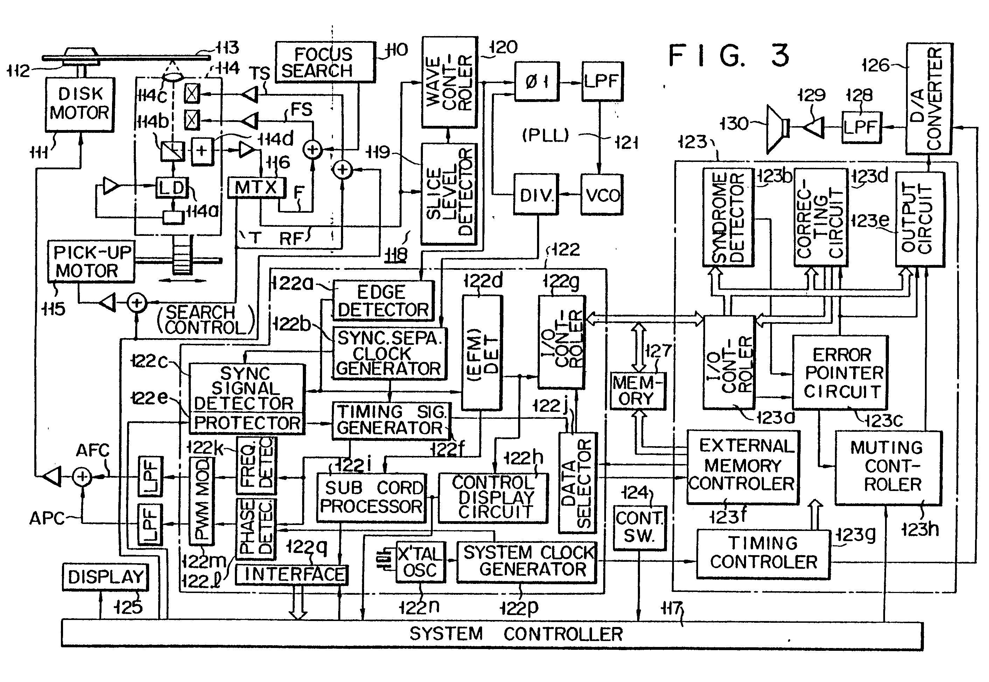

With reference to Fig. 3, an optical DAD (digital audio disk) device which uses compact disks will be described.

As shown in Fig. 3, the DAD device comprises a disk motor 111 for rotating a turntable 112. On the turntable 112 an optical disk 113 is mounted. The disk 113 has pits which correspond to digital audio signals (i.e. PCM codes) which have been EFM-modulated and interleaved. An optical pickup 114 emits a laser beam from a semi-conductor laser 114a. The laser beam passes through a beam splitter 114b and is focused by an object lens 114c. The beam illuminates the track of the optical disk 113. The beam reflected from the pits passes through the objective lens 114c and the beam splitter 114b. It is then guided to a four-element photodetector 114d. The photodetector 114d converts the laser beam into four signals. The pickup 114 is moved by a pickup feed motor 115 in the radial direction of the optical disk 113.

The four signals from the photodetector 114d are supplied to a matrix circuit 116 and undergo a specific matrix operation. As a result, the matrix circuit 116 generates a focus error signal F, a tracking error signal T and a high-frequency signal RF. The focus error signal F and a focus search signal from a focus search circuit 110 are used to drive a focus servo system of the optical pickup 114. The tracking error signal T and a search control signal supplied from a system controller 117 are used to drive a tracking servo system of the optical pickup 114 and to control the pickup feed motor 115. The high-frequency signal RF is supplied to a reproduced signal processing system *118* as a major reproduced signal component. In the system *118* the signal RF is supplied to a waveform shaping circuit 120 which is controlled by a slice level (eye pattern) detector 119. The waveform shaping circuit 120 divides the input signal into an unnecessary analog component and a necessary data component. The necessary data component is supplied to a sync clock reproducing circuit 121 of PLL type and also to an edge detector 112a of a first signal processing system 122.

A sync clock from the sync clock reproducing circuit 121 is supplied to a clock generating circuit 122b of the first signal processing system 122. In response to the sync clock, the clock generating circuit 122b generates a clock for dividing a sync signal into components. On the other hand, the necessary data component from the edge detector 122a is supplied to a sync signal detector 122c. The sync signal detector 122c divides the data components in response to a sync signal dividing clock from the clock generating circuits 122b. The necessary data component from the edge detector 122a is supplied also to a demodulating circuit 122d and then EFM-demodulated. A sync signal from the sync signal detector 122c is supplied to a sync signal protecting circuit 122e and then to a timing signal generating circuit 122f. A clock from the clock generating circuit 122b is supplied also to the timing signal generating circuit 122f. The timing signal generating circuit 122f generates a timing signal for processing input data.

An output signal from the demodulating circuit 122d is supplied through a data bus input/output control circuit 122g to an input/output control circuit 123a of a second signal processing system 123. The output signal from the demodulating circuit 122d contains a sub-code (i.e. a control signal) and a display signal component. The display signal component is supplied to a control display processing circuit 122h and the sub-code is supplied to a sub code processing circuit 122i.

The sub-code processing circuit 122i detects an error, if any, from the sub-code and corrects the error and then generates a sub-code data. The sub-code data is supplied to the system controller 117 through an interface circuit 122q which is connected to the system controller 117.

The system controller 117 includes a microcomputer, an interface circuit and a driver integrated circuit. In response to an instruction from a control switch 124 the system controller 117 controls the DAD device in a desired manner and causes a display device 125 to display the sub-code (e.g. index data about a piece of music to be reproduced).

A timing signal from the timing generating circuit 122f is supplied through a data selecting circuit 122j to the data bus input/output control circuit 122g and controls the data bus input/output control circuit 122g. The timing signal is supplied also to a frequency detector 122k and a phase detector 122l and further to a PWM modulator 122m. The timing signal from the PWM modulator 122m then undergoes automatic frequency control (AFC) and automatic phase control (APC) so as to rotate the disk motor 111 at a constant linear velocity (CLV).

The phase detector 122l is connected to receive a system clock from a system clock generating circuit 122p, which operates under the control of an output signal from a quartz crystal oscillator 122n.

The demodulated data from the input/output control circuit 123a of the second signal processing system 123 is supplied through a data output circuit 123e to a D/A (digital-to-analog) converter 126 after it has undergone necessary error correction, deinterleaving and data supplementation at a syndrome detector 123b, an error pointer control circuit 123c, and an error correction circuit 123d. The second signal processing system 123 includes an external memory control circuit 123f. The control circuit 123f cooperates with the data selecting circuit 122j of the first signal processing system 122 to control an external memory 127 which stores data necessary for correcting errors. Under the control of the circuits 123f and 122j the data are read from the external memory 127 and supplied to the input/output control circuit 123a.

The second signal processing system 123 further comprises a timing control circuit 123g and a muting control circuit 123h. The timing control circuit 123g is so designed as to supply, in response to a system clock from the system clock generating circuit 122p, a timing control signal which is necessary in correcting errors, supplementing data and converting digital data into analog data. The muting control circuit 123h is so designed as to achieve, in response to a control signal from the error pointer control circuit 123c or from the system controller 117, a specific muting control which is necessary in supplementing data and in starting and ending DAD reproduction.

An audio signal, or an analog output signal from the D/A converter 126 is supplied through a low pass filter 128 and an amplifier 129 to a loudspeaker 130.

Now, the error data correcting system according to the present invention, which is applied to the DAD device described above, will be described in detail.

The principle of the error data correcting system will first be described. A double correction BCH code consists of symbols which are the elements of Galois field FG($2^8$) and which are:

$$U_0, U_1, U_2 \ldots U_{M-1}, P_0, P_1, P_2, P_3 \qquad (12)$$

$U_0$—$U_{M-1}$ are data symbols, each being an 8-bit symbol. $P_0$—$P_3$ are parity symbols. That is, M data symbols and four parity symbols make the double correction BCH code. Equation (12) implies that the parity symbols are regarded as identical with data symbols so far as error correction is concerned. Expression (12) may be changed to:

$$W_{M+3}, W_{M+2}, W_{M+1} \ldots W_3, W_2, W_1, W_0, \qquad (13)$$

Hence, transmission polynomial $F_{(x)}$ is given by:

$$F_{(x)} = W_{M+3}x^{M+3} + W_{M+2}x^{M+2} + \ldots + W_{1x} + W_0 \qquad (14)$$

And reception polynomial $F_{(x)'}$ is given by:

$$F_{(x)} = W_{M+3'}x^{M+3} + W_{M+2'}x^{M+2} + \ldots W_{1'x} + W_0 \qquad (15)$$

Let $\alpha$ denote one of the roots of the generator polynomial $G_{(x)}$ of Galois field GF($2^8$). The transmission polynomial then has four roots 1, $\alpha$, $\alpha^2$ and $\alpha^3$. Therefore:

$$
\left.
\begin{aligned}
F(1) &= \sum_{i=0}^{M+3} W_i = 0 \\
F(\alpha) &= \sum_{i=0}^{M+3} W_i \alpha^i = 0 \\
F(\alpha^2) &= \sum_{i=0}^{M+3} W_i (\alpha^2)^i = 0 \\
F(\alpha^3) &= \sum_{i=0}^{M+3} W_i (\alpha^3)^i = 0
\end{aligned}
\right\} \qquad (16)
$$

From the transmitting station such parity symbols as would satisfy expression (13) are transmitted,

8

while at the receiving station those of the parity symbols which are distorted by the transmission system are detected as errors and then corrected.

In the case of the double error BCH code described above, two symbol errors at most can be corrected. Suppose two symbols $W_i'$ and $W_j'$ included in the reception polynomial $F_{(x)'}$ are made erroneous. Then:

$$W_{i'} = W_i + e_i$$

$$W_{j'} = W_j + e_j.$$

No symbol other than symbols $W_{i'}$ and $W_{j'}$ is erroneous. That is:

$$W'_k = W_k \quad (k=0 \text{ to } M+3, \ k \neq i, \ k \neq j).$$

Substituting 1, $\alpha$, $\alpha^2$ and $\alpha^3$ in the reception polynomial $F_{(x)'}$ or equation (15), yields:

$$\left. \begin{array}{l} F_{(1)'} = e_i + e_j = S_0 \\ F_{(\alpha)'} = e_i \alpha^i + e_j \alpha^j = S_1 \\ F_{(\alpha^2)'} = e_i \alpha^{2i} + e_j \alpha^{2j} = S2 \\ F_{(\alpha^3)'} = e_i \alpha^{3i} + e_j \alpha^{3j} = S3 \end{array} \right\} \tag{17}$$

Here, $S_0$—$S_3$ are syndromes, each representing the value given in equation (17) in case two of $(M+3)$ symbols which constitute the double correction BCH code.

In correcting errors, using a BCH code theory, such an error location polynomial as described above may be used. If this is the case:

$$\sigma_1 = \alpha^i + \alpha^j = \frac{S_0 \ S_3 + S_1 \ S_2}{S_1^2 + S_0 \ S_2} \tag{18}$$

$$\sigma_2 = \alpha^i \ \alpha^j = \frac{S_1 \ S_3 + S_2^2}{S_1^2 + S_0 \ S_2} \tag{19}$$

$$f_{(x)} = x^2 + \sigma_1 x + \sigma_2 \tag{20}$$

That is, from syndromes $S_0$ to $S_3$, $\sigma_1$ and $\sigma_2$ are obtained in such way as indicated by equations (18) and (19). $\sigma_1$ and $\sigma_2$ thus obtained are then substituted in equation (20). In this case, x in equation (20) is substituted by $\alpha^0$, $\alpha^1$, $\alpha^2$,... $\alpha^{M+3}$, one after another. Obviously, $f_{(x)} = 0$ when x is substituted by $\alpha^i$ and $\alpha^j$. Two error locations will thus be found where $f_{(x)} = 0$.

An error pattern is obtained by using known $\alpha^i$ and $\alpha^j$. More specifically, from equations (17):

$$e_i = \frac{S_0 \ \alpha^j + S_1}{\alpha^i + \alpha^j} \tag{21A}$$

$$e_j = S_0 + e_i \tag{21B}$$

As mentioned above, the object of the present invention is to provide an error data correcting system which can perform multiplications and divisions on the elements of Galois field without using memories of a large memory capacity. However, without memories of a large memory capacity it would be difficult to perform divisions on the elements of Galois field with a generator polynomial $g_{(x)}$, though it is possible to perform relatively simple multiplications. It is therefore preferred that as less divisions as possible be performed in order to obtain error locations and an error pattern.

An error location polynomial is generated in the following manner.

The denominator in the right side of equation (18) is identical with that in the right side of equation (19). Let $S_a$, $S_b$ and $S_c$ be put to be:

$$\left. \begin{array}{l} S_a = S_1^2 + S_0 \ S_2 \\ S_b = S_0 \ S_3 + S_1 \ S_2 \\ S_c = S_1 \ S_3 + S_2^2 \end{array} \right\} \tag{22}$$

Then, equations (18) and (19) will be changed to:

$$\sigma_1 = \alpha^i + \alpha^j = \frac{S_b}{S_a} \qquad (23)$$

$$\sigma_2 = \alpha^i \alpha^j = \frac{S_c}{S_a} \qquad (24)$$

Substituting equations (23) and (24) in equation (20) there will yield:

$$f_{(x)} = x^2 + \frac{S_b}{S_a} x + \frac{S_c}{S_a} \qquad (25)$$

Equation (25) shows that error locations will be identified if x is substituted by $\alpha^0, \alpha^1, \alpha^2 \ldots \alpha^{M+3}$, thereby finding locations where $f_{(x)} = 0$. Even if equation (25) is changed to the following one:

$$f'_{(x)} = S_a f_{(x)} = S_a x^2 + S_b x + S_c \qquad (26)$$

$\alpha^i$ and $\alpha^j$ will be identified by substituting x by $\alpha^0, \alpha^1, \alpha^2 \ldots \alpha^{M+3}$ one after another and by finding locations where $f'_{(x)} = 0$. In this way, an error location polynomial can be generated without performing divisions.

An error pattern is generated in the following manner.

The right side of equation (21A) which represents a division is:

$$\frac{S_0 \alpha^j + S_1}{\alpha^i + \alpha^j}$$

If the reciprocal $(\alpha^i + \alpha^j)^{-1}$ of the denominator $\alpha^i + \alpha^j$ of the right side is known, equation (21A) is then changed to:

$$e_i = (S_0 \alpha^j + S_1)(\alpha^i + \alpha^j)^{-1} \qquad (21A')$$

That is, no division needs to be performed in order to fine $e_i$. Reciprocal $(\alpha^i + \alpha^j)^{-1}$ is obtained in the following way. First, equation (26) is substituted in equation (23). Then:

$$f'_{(x)} = S_a x^2 + S_a(\alpha^i + \alpha^j)x + S_c \qquad (27)$$

In order to find error locations it is necessary to substitute x in equation (27) by $\alpha^0, \alpha^1, \alpha^2 \ldots \alpha^{M+3}$. While substituting x by $\alpha^0, \alpha^1, \alpha^2 \ldots \alpha^{M+3}$ one after another, the value for x which would satisfy the following equation (28) is calculated.

$$S_a(\alpha^i + \alpha^j)x = \alpha^r \qquad (28)$$

More specifically, assume that m=28. Then, x in equation (28) must be substituted by $\alpha^0$ to $\alpha^{31}$. The greatest element of Galois field $GF(2^8)$ is:

$$\alpha 2^8 - 1 = \alpha^{255} = 1.$$

Obviously, $\alpha^{255}$ is identical with $\alpha^0$. In other words, $\alpha^{255}$ is a cyclic code for elements $\alpha^0 - \alpha^{254}$. It is therefore sufficient to substitute only $\alpha^0 - \alpha^{254}$ for x in equation (28) in order to find error locations.

In this case, $\alpha^0 - \alpha^{31}$ are substituted for x. Since $7 < 255/32 < 8$, eight data $\alpha^{32z}$ (z=0 to 7) and eight reciprocal data $\alpha^{-32z}$ (z=0 to 7) are encoded as shown in the following table:

| | |
|---|---|
| $\alpha^{32z}$ | $\alpha^{-32z}$ |
| $\alpha^{0}$ | $\alpha^{255}$ |
| $\alpha^{32}$ | $\alpha^{223}$ |
| $\alpha^{64}$ | $\alpha^{191}$ |
| $\alpha^{96}$ | $\alpha^{159}$ |
| $\alpha^{128}$ | $\alpha^{127}$ |
| $\alpha^{166}$ | $\alpha^{95}$ |
| $\alpha^{192}$ | $\alpha^{63}$ |
| $\alpha^{224}$ | $\alpha^{31}$ |
| $z=0,\ 1,\ 2,\ \ldots 7$ | |

That is, while substituting $\alpha^{0}$—$\alpha^{31}$ for x, $S_a(\alpha^{i}+\alpha^{j})x$ will be equal to $\alpha^{32z}$ when r=32z. Suppose x=$\alpha^{g}$ when $S_a(\alpha^{i}+\alpha^{j})x$ equals to $\alpha^{32m}$. Then, equation (28) is changed to the following one:

$$S_a(\alpha^{i}+\alpha^{j})\alpha^{q}=\alpha^{32z} \tag{29}$$

From $\alpha^{q}$ and the code table given above, $\alpha^{-32z}$ is identified. Hence:

$$(\alpha^{i}+\alpha^{j})^{-1}=S_a \cdot \alpha^{q} \cdot \alpha^{-32z} \tag{30}$$

To sum up the above, the data processing time can be reduced if reciprocal data which are necessary for obtaining an error pattern are given while error locations are being identified.

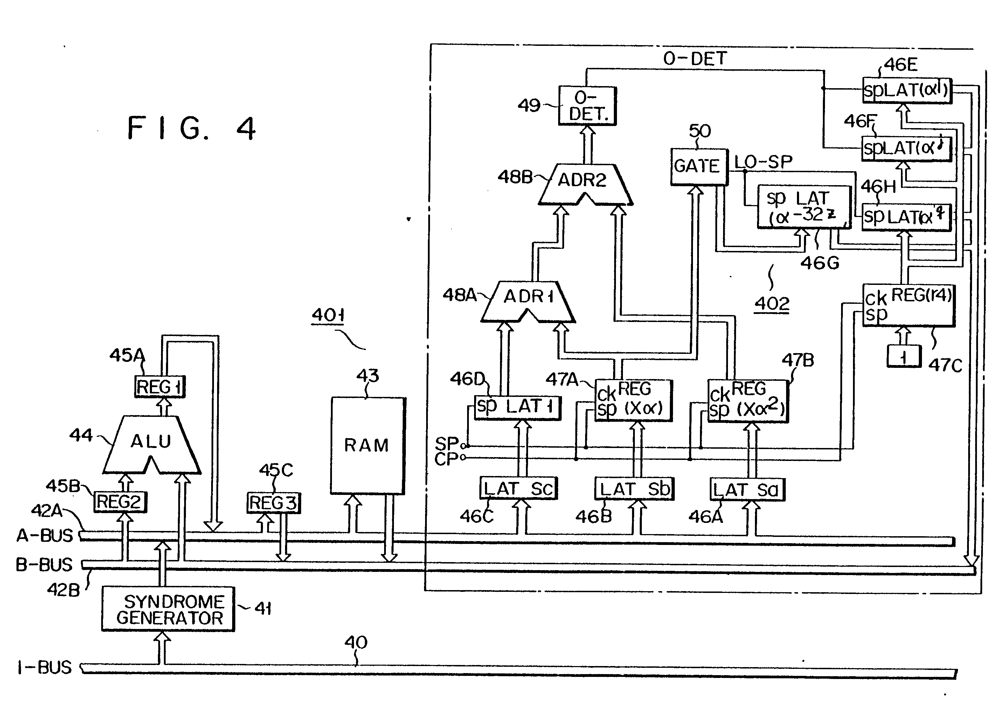

Now, an embodiment of the invention which is based on the above-mentioned principle will be described with reference to Fig. 4.

Fig. 4 is a block diagram of an error location polynomial calculating unit which is included chiefly in the correction circuit 123d of the second signal processing system 123 shown in Fig. 3. The calculating unit is to perform various algebraic operations in order to decode a reed Solomon code (i.e. error correction code), a kind of a BCH code which is used as an error correction code, and thereby to genreate an error location polynomial and an error pattern. The algebraic operations which need to be performed in order to generate an error location polynomial and an error pattern are only addition and multiplication; no division is necessary.

The error location polynomial calculating unit decodes a reed Solomon code as will be described below.

Reproduced symbols $W_{M+3}$, $W_{M+2}$, $W_{M+1}$, . ., $W_0$ are supplied to a syndrome generator (SYNDROME GEN.) 41 which corresponds to the syndrome detector 123b shown in Fig. 3. The syndrome generator 41 generates syndromes $S_0$—$S_3$ which are given by equations (16). Syndromes $S_0$—$S_3$ are stored into a memory (RAM) 43 through a transfer bus (A-BUS) 42A. Syndromes $S_0$—$S_3$ are read out from the memory 43 whenever necessary. They are supplied through a transfer bus (B-Bus) 42B to an arithmetic logic unit (ALU) 44, a register (REG 1) 45A, a register (REG 2) 45B and a register (REG 3) 45C, thereby obtaining $S_a$, $S_b$ and $S_c$ which are represented by equations (22).

The arithmetic logic unit 44 is so designed as to perform addition and multiplication on the elements of Galois field. In includes a multiplier, which will hereinafter be described.

Through the transfer bus 42A, $S_c$, $S_b$ and $S_a$ are supplied to a latch circuit (LAT-$S_c$) 46C, a latch circuit (LAT-$S_b$) 46B and a latch circuit (LAT-$S_a$) 46A, respectively. $S_c$, $S_b$ and $S_a$ are supplied to a latch circuit (LAT-1) 46D, an $\alpha$ multiplying register (REG x$\alpha$) 47A and an $\alpha^2$ multiplying register (REG x$\alpha^2$) 47B, respectively, when a set pulse SP is supplied to the latch circuit 46D, the $\alpha$ multiplying register 47A and the $\alpha^2$ multiplying register 47B. At the same time, "1" is supplied to a r4 register (REG r4) 47C.

The $\alpha$ multiplying register 47A multiplies its contents by $\alpha$ upon receipt of a clock pulse CP. Similarly, the $\alpha^2$ multiplying register 47B multiplies its contents by $\alpha^2$ upon receipt of a clock pulse CP. The r4 register 47C is set to "1" at first and multiplies its contents by $\alpha$ every time it receives a clock pulse CP. In this embodiment, the r4 register 47C generates $\alpha^0$ to $\alpha^{31}$.

After $S_c$, $S_b$, $S_a$ and "1" have been stored into the latch circuit 46D, $\alpha$ multiplying register 47A, $\alpha^2$ multipyling register 47B and r4 register 47C, respectively, 31 clock pulses CP are supplied, one after another, to the circuit 46D, regsiter 47A, register 47B and register 47C, thus solving equation (26) which is a quadratic equation. More precisely, output $S_c$ from the latch circuit 46D and output $S_b(=S_b x)$ from the $\alpha$ multiplying register 47A are supplied to an adder circuit (ADR1) 48A and thus added together. Further, output $S_a \alpha^2$ from the $\alpha^2$ multiplying register 47B and the output $S_c + S_b(=S_c + S_b x)$ from the adder circuit 48A are supplied to an adder circuit (ADR2) 48B and added together. As a result, there is found:

$$S_a \alpha^2 + S_b \alpha + S_c (= S_a x^2 + S_b x + S_c = f_{(x)'}).$$

Then, x in quadratic equation (26) is substituted by $\alpha^0$ to $\alpha^{31}$ as 31 clock pulses CP are supplied. When $f_{(x)'} = 0$, the adder circuit (ADR2) 48B generates "0". If a zero detector (0-DET) 49 detects "0" twice, it means that the two roots of the quadratic equation have been determined.

When the zero detector (0-DET) 49 detects "0", it generates an output signal. The contents of the r4 register (REG r4) 47C are then stored into a latch circuit (LAT $\alpha^i$) 46E and a latch circuit (LAT$\alpha^j$) 46F, whereby $\alpha^i$ and $\alpha^j$ which define an error location can be determined. Data representing $\alpha^i$ and $\alpha^j$ are transferred to the arithmetic logic unit (ALU) 44 through the transfer bus (B-BUS) 42B. The arithmetic logic unit (ALU) 44 multiplies $\alpha^i$ by $\alpha^j$ as indicated by equation (19) and adds $\alpha^i$ to $\alpha^j$ as indicated by equation (18), thus generating error locations $\sigma_1$ and $\sigma_2$.

In generating error locations $\sigma_1$ and $\sigma_2$, an output from the $\alpha$ multiplying register (REG x$\alpha$) 47A is supplied to a gate circuit (GATE) 50. The gate circuit (GATE) 50 generates an output which represents the reciprocal of the output from the register (REG x$\alpha$) 47A (see the table given above). More specifically, when an output from the $\alpha$ multiplying register (REG x$\alpha$) 47A represents any value shown in the right column of the table (i.e. the $\alpha^{32z}$ column), the gate circuit (GATE) 50 generates a load pulse. A data representing one of the values shown in the left column of the table (i.e. the $\alpha^{-32z}$ column), which is the reciprocal of the value represented by the output from the register (REG x$\alpha$) 47A, is then read from the gate circuit (GATE) 50 and stored into a latch circuit (LAT $\alpha^{-32z}$) 46G. At the same time, the contents of the r4 register (REG r4) 47C, i.e. data $\alpha^q$, are stored into a latch circuit (LAT $\alpha^q$) 46H. Hence, data representing $\alpha^q$ and $\alpha^{-32z}$ which are necessary for defining an error pattern are obtained.

The data representing $\alpha^q$ and the data $\alpha^{-32z}$ are transferred to the arithmetic logic unit (ALU) 44 through the transfer bus (B-BUS) 42B. Data representing $S_a$ is transferred also to the arithmetic logic unit (ALU) 44 through the transfer bus (B-BUS) 42B. The unit (ALU) 44 performs the multiplication, $S_a \cdot \alpha^q \cdot \alpha^{-32z}$ in equation (30), thereby obtaining a reciprocal $(\alpha^i + \alpha^j)^{-1}$. Thereafter, the unit (ALU) 44 performs such a multiplication as given by equation (21A') and such an addition as given by equation (21B), thereby generating error patterns $e_1$ and $e_2$.

Using error locations $\sigma_1$ and $\sigma_2$ and error patterns $e_1$ and $e_2$ thus generated, an error is corrected in such a method as described above with reference to Fig. 1.

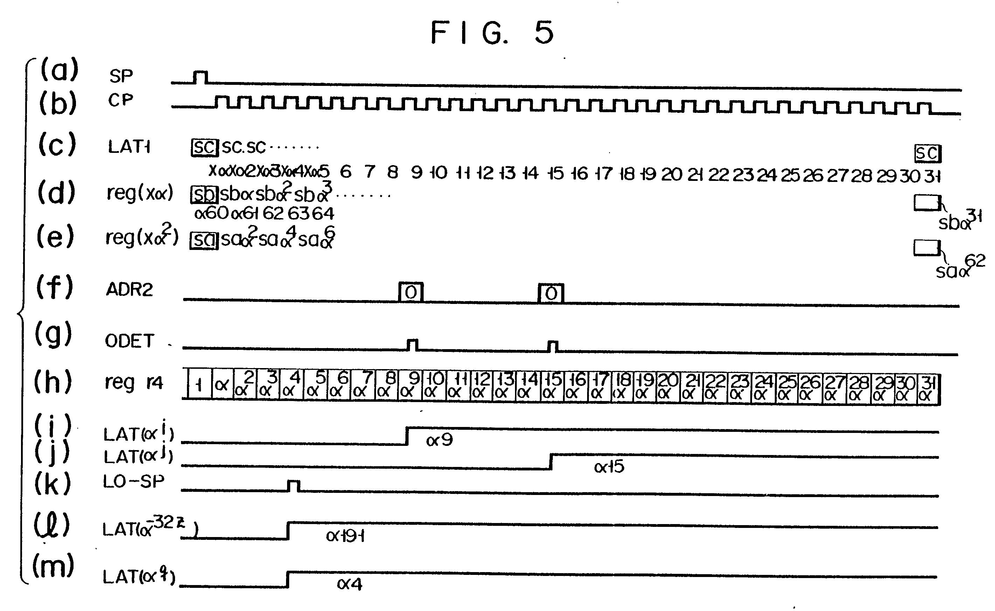

Fig. 5 is a timing chart illustrating how to correct an error when $S_b = S_a(\alpha^i + \alpha^j) = \alpha^{60}$, where $\alpha^i = \alpha^9$ and $\alpha^j$ and $\alpha^j = \alpha^{15}$. In Fig. 5, (a) is a set pulse SP, (b) is a clock pulse CP, (c) is the contents of the latch circuit (LAT 1), (d) is the contents of the $\alpha$ multiplying register (REG x$\alpha$), (e) is the contents of the $\alpha^2$ multiplying register (REG x$\alpha^2$), (f) is an output from the adder circuit (ADR2), (g) is an output from the zero detector (0-DET), (h) is the contents of the r4 register (REG r4), (i) is the contents of the latch circuit (LAT $\alpha^i$), (j) is the contents of the latch circuit (LAT $\alpha^j$), (k) is a load pulse from the gate circuit (GATE), (l) is the contents of the latch circuit (LAT $\alpha^{-32z}$), and (m) is the contents of the latch circuit (LAT $\alpha^q$).

Now the multiplier included in the arithmetic logic unit (ALU) 44 will be described. A multiplication on the elements of Galois field is expressed as follows:

$$A(\alpha) = B(\alpha) \cdot C(\alpha).$$

If

$$B(\alpha) = b_7 \alpha^7 + b_6 \alpha^6 + \ldots + b_0$$

$$C(\alpha) = c_7 \alpha^7 + c_7 \alpha^6 + \ldots + c_0,$$

then:

$$B(\alpha) \cdot C(\alpha) = B(\alpha)[(c_7 \alpha^6 + c_5 \alpha^5 + c_3 \alpha^2 + c_1) + (c_6 \alpha^6 + c_4 \alpha^4 + c_2 \alpha^2 + c_0)]$$

$$= [\alpha B(\alpha)](c_7 \alpha^6 + c_5 \alpha^4 + c_3 \alpha^2 + c_1) + B(\alpha)(c_6 \alpha^6 + c_4 \alpha^4 + c_2 \alpha^2 + c_0) \tag{31}$$

where $\alpha$ is the root of the generator polynomial $g_{(x)}$ of Galois field $GF(2^8)$.

Equation (31) implies that the first term in the right side can be determined in one step and the second term in the right side can be determined in another step.

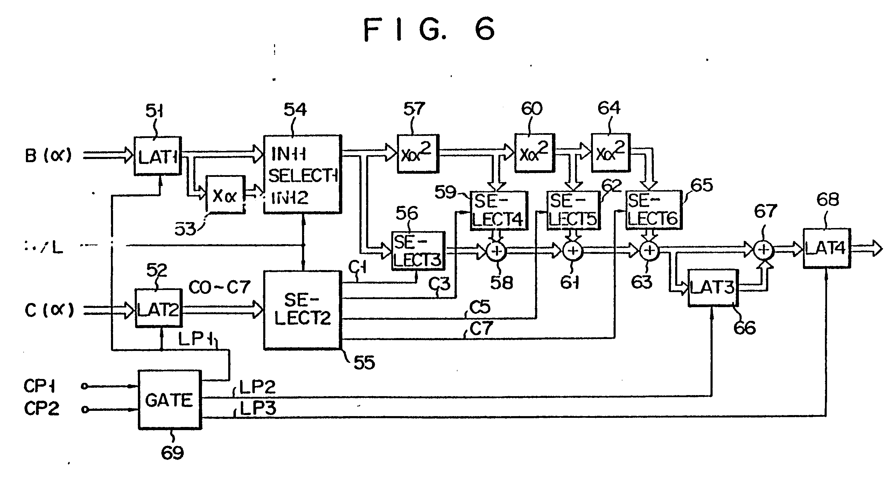

Fig. 6 is a block diagram of the multiplier which is included in the arithmetic logic unit (ALU) 44. A multiplicand data $B(\alpha)$ is latched by a latch circuit 51, and a multiplier data $C(\alpha)$ is latched by a latch circuit 52. An output from the latch circuit 51 is supplied to the first input terminal $IN_{11}$ of a selector circuit 54 and also to the second input terminal $IN_{12}$ of the circuit 54 through an $\alpha$ multiplying circuit 53. From the latch circuit 52 the coefficients $c_0$ to $c_7$ of the multiplier data $C(\alpha)$ are supplied at the same time to the seven input terminals of a selector circuit 55, respectively.

The selector circuits 54 and 55 are connected to receive a selector signal H/L. When a selector signal having a high level H is supplied to both selector circuits 54 and 55, the multiplier performs the multiplication given by the following equation (32). Conversely, when a selector signal having a low level L is supplied to both selector circuits 54 and 55, the multiplier performs the multiplication given by the following equation (33):

$$[\alpha B(\alpha)](c_7\alpha^6+c_5\alpha^4+c_3\alpha^2+c_1) \qquad (32)$$

$$B(\alpha)(c_6\alpha^6+c_6\alpha^4+c_2\alpha^2+c_0) \qquad (33)$$

The multiplier performs the multiplication of equation (32) in the following manner.

Upon receipt of a selector signal of a high level H, the selector circuit 54 selects the input data $[\alpha B(\alpha)]$ supplied to its second input terminal $IN_{12}$ and the selector circuit 55 supplies outputs $c_1$, $c_3$, $c_5$ and $c_7$ from its first, second, third and fourth output terminals, respectively. Data $[\alpha B(\alpha)]$ is supplied to a selector circuit 56 and also to an $\alpha^2$ multiplying circuit 57. The selector circuit 56 has its gate controlled by output $c_1$ from the selector circuit 55. Upon receipt of output $c_1$ the selector circuit 56 supplies an output $[\alpha B(\alpha)]$ to one input terminal of an exclusive OR circuit 58. The $\alpha^2$ multiplying circuit 57 multiplies the input data $[\alpha B(\alpha)]$ by $\alpha^2$, thereby generating an output $[\alpha^3 B(\alpha)]$. Output $[\alpha^3 B(\alpha)]$ from the $\alpha^2$ multiplying circuit 57 is supplied to a selector circuit 59 and also to an $\alpha^2$ multiplying circuit 60.

The selector circuit 59 has its gate controlled by output $c_3$ from the selector circuit 55. Upon receipt of output $c_3$ it supplies an output $[\alpha^3 B(\alpha)]$ to the other input terminal of the exclusive OR circuit 58. Output $[\alpha B(\alpha)+\alpha^3 B(\alpha)]$ from the exclusive OR circuit 58 is supplied to one input terminal of an exclusive OR circuit 61.

In the meantime, the $\alpha^2$ multiplying circuit 60 multiplies the input data $[\alpha^2 B(\alpha)]$ by $\alpha^2$, thereby generating an output $[\alpha^5 B(\alpha)]$. Output $[\alpha^5 B(\alpha)]$ is supplied to a selector circuit 62 and also to an $\alpha^2$ multiplying circuit 64. The selector circuit 62 has its gate controlled by output $c_5$ from the selector circuit 55. Upon receipt of output $c_5$ it supplies an output $[\alpha^5 B(\alpha)]$ to the other input terminal of the exclusive OR circuit 61. Output $[\alpha B(\alpha)+\alpha^3 B(\alpha)+\alpha^5 B(\alpha)]$ from the exclusive OR circuit 61 is supplied to one input terminal of an exclusive OR circuit 63.

Meanwhile, the $\alpha^2$ multiplying circuit 64 multiplies the input data $[\alpha^5 B(\alpha)]$ by $\alpha^2$, thus generating an output $[\alpha^7 B(\alpha)]$. Output $[\alpha^7 B(\alpha)]$ is supplied to a selector circuit 65. The selector circuit 65 has its gate controlled by output $c_7$ from the selector circuit 55. Upon receipt of output $c_7$ it supplies an output $[\alpha^7 B(\alpha)]$ to the other input terminal of the exclusive OR circuit 63. Output $[\alpha B(\alpha)+\alpha^3 B(\alpha)+\alpha^5 B(\alpha)+\alpha^7 B(\alpha)]$ from the exclusive OR circuit 63 is supplied to a latch circuit 66 and also to one input terminal of an exclusive OR circuit 67. The output from the latch circuit 66 is supplied to the other input terminal of the exclusive OR circuit 67. The output from the exclusive OR circuit 67 is supplied to a latch circuit 68.

Briefly stated when a selector signal of a high level H is supplied the selector circuits 54 and 55, the latch circuit 66 will store data $[\alpha B(\alpha)]$

$$(c_7\alpha^6+c_5\alpha^4+c_3\alpha^2+c_1).$$

When a selector signal of a low level L is supplied to the selector circuits 54 and 55, the sequence of the above-mentioned steps will be carried out, thereby supplying data $B(\alpha)(c_6\alpha^6+c_4\alpha^4+c_2\alpha^2+c_0)$ to one input terminal of the exlcusive OR circuit 67. The output from the latch circuit 66 is supplied to the other input terminal of the exclusive OR circuit 67, whereby data of equation (32) and data of equation (33) are added together. As a result, data $B(\alpha) \cdot C(\alpha)$ given by equation (31) is supplied to the latch circuit 68.

The latch circuits 51 and 52 are controlled by a latch signal $LP_1$ generated by a gate circuit 69 which is connected to receive 2-phase reference clocks $CP_1$ and $CP_2$. The latch circuit 66 is controlled by a latch signal $LP_2$ generated by the gate circuit 69. Similarly, the latch circuit 68 is controlled by a latch signal $LP_3$ generated by the gate circuit 69.

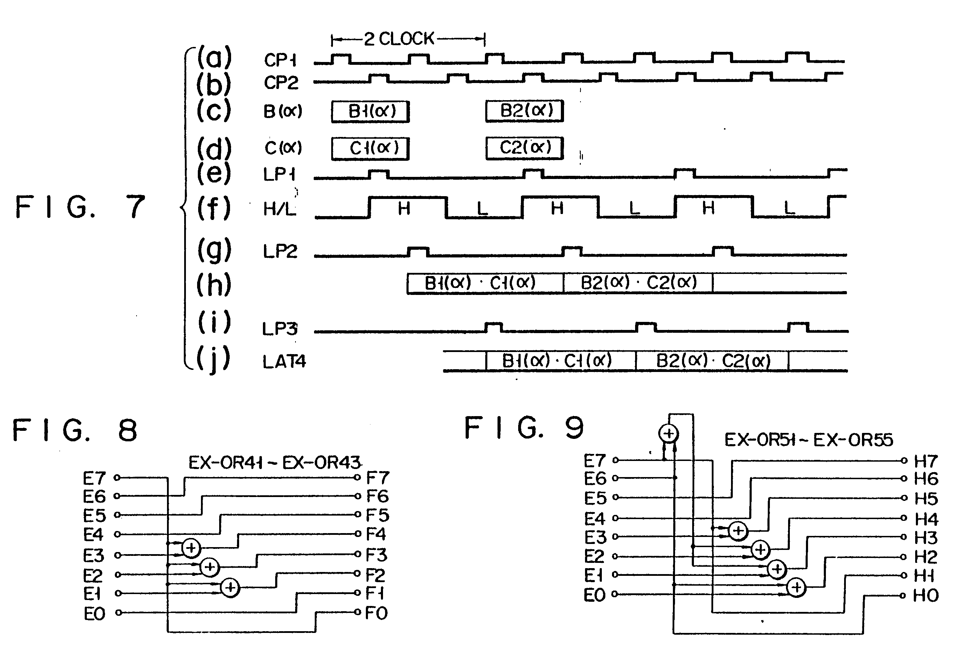

Fig. 7 is a timing chart illustrating how the multiplier operates which is included in the arithmetic logic unit (ALU) 44. In Fig. 7, (a) is a reference clock $CP_1$, (b) is a reference clock $CP_2$, (c) indicates the timing of inputting multiplicand data $B(\alpha)$, (d) indicates the timing of inputting multiplier data $C(\alpha)$, (e) is a latch signal $LP_1$, (f) is a selector signal H/L, (g) is a latch signal $LP_2$, (h) indicates the timing of latching data in the latch circuit 66, (i) is a latch signal $LP_3$, and (j) indicates the timing of latching data in the latch circuit 68.

Now, the $\alpha$ multiplying circuit 53 and the $\alpha^2$ multiplying circuits 57, 60 and 64 will be described in detail. $\alpha$ is the roots of the generator polynomial $g_{(x)}$ of Galois field $GF(2^8)$, which is given by:

$$g_{(x)}=x^8+x^4+x^3+x^2+1.$$

Hence:

$$g_{(\alpha)}=\alpha^8+\alpha^4+\alpha^3+\alpha^2+1=0.$$

From the above equation:

$$\alpha^8=\alpha^4+\alpha^3+\alpha^2+1 \qquad (34)$$

13

If a multiplicand data $E(\alpha)$, which is given as follows, is multiplied by $\alpha$, the product will be expressed by the following equation (35) from equation (34):

$$E(\alpha)=E_7\alpha^7+E_6\alpha^6+\ldots+E_0.$$

$$E(\alpha)\cdot\alpha=E_7\alpha^8+E_6\alpha^7+\ldots+E_0$$

$$=E_6\alpha^7+E_5\alpha^6+E_4\alpha^5+(E_3+E_7)\alpha^6$$

$$+(E_2+E_7)\alpha^3+(E_1+E_7)\alpha^2+E_0\alpha+E_7$$

$$=F_7\alpha^7+F_6\alpha^6+F_5\alpha^5+F_4\alpha^4+F_3\alpha^3+F_2\alpha^2+F_1\alpha+F_0 \tag{35}$$

Equation (35) means that the $\alpha$ multiplying circuit 53 may be comprised of exclusive OR circuits (EX-OR$_{41}$) to (EX-OR$_{43}$) as shown in Fig. 8.

Product $E(\alpha)\cdot\alpha^2$ will be expressed as follows:

$$E(\alpha)\cdot\alpha^2=E_6\alpha^8+E_5\alpha^7+E_4\alpha^6+(E_2+E_7)\alpha^4+(E_1+E_7)\alpha^3+E_0\alpha^2+E_7\alpha$$

$$=E_5\alpha^7+E_4\alpha^6+(E_3+E_7)\alpha^5+(E_2+E_6+E_7)\alpha^4+(E_1+E_6+E_7)\alpha^3$$

$$+(E_0+E_6)\alpha^2+E_7\alpha+E_7$$

$$=H_7\alpha^7+H_6\alpha^6+H_5\alpha^5+H_4\alpha^4+H_3\alpha^3+H_2\alpha^2+H_1\alpha+H_0 \tag{36}$$

It is obvious from equation (36) that the $\alpha^2$ multiplying circuits 57, 60 and 64 can be comprised of exclusive OR circuits (EX-OR$_{51}$) to (EX-OR$_{55}$) as illustrated in Fig. 9.

The present invention may be applied to devices other than a DAD device. For instance, the error data correcting system of the invention can be used in combination with an apparatus for recording digital data such as PCM codes on a magnetic tape, reproducing the data from the tape and transmitting the data.

As described above in detail, the error data correcting system according to the invention can perform multiplication and addition on the elements of Galois field thereby to generate error locations and error patterns, without using memories of a large memory capacity such as a logarithm buffer or an antilogarithm buffer. The system is therefore simple and inexpensive and can process data at a high speed.

**Claims**

1. An error correcting system which recieves double correction BCH codes each consisting of M data symbols and four parity symbols, each consisting of m bits and represented by the following generator polynomial:

$$g_{(x)}=(x+1)(x+\alpha)(x+\alpha^2)(x+\alpha^3),$$

where $\alpha$ is the origin element of Galois field GF ($2^m$), and which system finds the roots of the following error location polynomial:

$$f_{(x)}=x^2+\sigma_1 x+\sigma_2,$$

thereby correcting errors in the double correction BCH codes, said system comprising:
means for storing the double correction BCH codes;
syndrome generating means (41) for generating four syndromes $S_0$, $S_1$, $S_2$ and $S_3$ from the double correction BCH codes;
error locating calculating means (401) comprising:
a first multiplying/adding section (44) for multiplying and adding the four syndromes $S_0$, $S_1$, $S_2$ and $S_3$ to obtain three parameters $S_a$, $S_b$ and $S_c$ which are given as follows:

$$S_a=S_1^2+S_0\,S_2,$$

$$S_b=S_0\,S_3+S_1\,S_2,$$

$$S_c=S_1\,S_3+S_2^2,$$

a second multiplying/adding section (47A-C, 48A-B) for performing multiplication and addition while successively substituting $\alpha^0$ to $\alpha^{M+3}$ for x in the following polynomial obtained by transforming said error location polynomial $f_{(x)}$:

14

$$f'_{(x)}=S_a f_{(x)}=S_a x^2+S_b x+S_c,$$

thereby obtaining two products $S_a \cdot \alpha^2$ and $S_b \cdot \alpha$ and a sum $S_a \alpha^2+S_b \alpha+S_c$, utilizing the fact that the coefficients $\sigma_1$, $\sigma_2$ of said error location polynomial $f_{(x)}$ and the three syndromes $S_a$, $S_b$ and $S_c$ have the following relations according to the theory on the correction of said double correction BCH codes:

$$\sigma_1=S_b/S_a=\alpha^i+\alpha^j,$$

$$\sigma_2=S_c/S_a=\alpha^i \ \alpha^j;$$

an $\alpha^i$, $\alpha^j$ detecting section (49) for detecting $\alpha^i$ and $\alpha^j$ which satisfy $f'_{(x)}=0$ during the succesisve substitutions for x, and a third multiplying/adding section (44) for adding $\alpha^i$ and $\alpha^j$ and multiplying $\alpha^i$ by $\alpha^j$, thereby finding the coefficients $\sigma_1$, $\sigma_2$ which define error locations;

error pattern calculating means comprising a fourth multiplying/adding means (44) for obtaining an error pattern $e_i$ from $\alpha^i$ and $\alpha^j$ by performing the following multiplication.

$$e_i=(S_0\alpha^j+S_1)(\alpha^i+\alpha^j)^{-1},$$

said equation having been derived from the following division:

$$e_i=\frac{S_0\alpha^j+S_1}{\alpha^i+\alpha^j},$$

and for obtaining another error pattern $e_j$ by performing the following addition:

$$e_j=S_0+e_i; \text{ and}$$

correction means for correcting the errors in said double correction codes stored by said code storing means in accordance with the coefficients $\sigma_1$, $\sigma_2$ and the error patterns $e_i$, $e_j$

wherein said fourth multiplying/adding section includes means for finding a reciprocal component $(\alpha^i+\alpha^j)^{-1}$ which is used to obtain the error pattern $e_i$ and which is given by the following equation:

$$(\alpha^i+\alpha^j)^{-1}=Sa \cdot \alpha^q \cdot \alpha^{-(M+4)z},$$

where $\alpha^q$ is the value for x which satisfies

$$Sa(\alpha^i+\alpha^j)x=Sb \cdot x=\alpha^{(M+4)z},$$

when successively substituting the values $\alpha^0$ to $\alpha^{M+3}$ for x and where z may take one of the values 0, 1, ...(l-1), with l being the nearest higher integer of $(2^m-1)/(M+4)$, said means comprising:

table means (50) having l entries, each entry giving for a value $\alpha^{(M+4)z}$ the reciprocal value $\alpha^{-(M+4)z}$;

latch circuit means (46G, 46H) for latching $\alpha^{-(M+4)z}$ stored in said table means corresponding to the entry of the table where $\alpha^{(M+4)z}$ is coincident to $S_b\alpha$, which is successively output from said second multiplying/adding section when x is substituted by $\alpha^0$ to $\alpha^{M+3}$, and latching at that time the value taken by x as data $\alpha^q$; and

multiplying means (44) for multiplying $\alpha^{-(M+4)z}$, $S_a$ and $\alpha^q$.

2. An error correcting system according to claim 1, wherein said first, third and fourth multiplying/adding sections are comprised of one section (44).

3. An error correcting system according to claim 1, wherein said first, third and fourth multiplying/adding sections (44) each include a multiplier unit which performs the following multiplication:

$$B(\alpha) \cdot C(\alpha)=M_1+M_2,$$

where:

$$B(\alpha)=b_{m-1}\alpha^{m-1}+b_{m-2}\alpha^{m-2}+...+b_0,$$

$$C(\alpha)=C_{m-1}\alpha^{m-1}+C_{m-2}\alpha^{m-2}+...+C_0,$$

provided that:

$$M_1=\{\alpha B(\alpha)\}(C_{m-1}\alpha^{m-2}+C_{m-3}\alpha^{m-4}+...+C_3\alpha^2+C_1)$$

$$M_2=B(\alpha)(C_{m-2}\alpha^{m-2}+C_{m-4}\alpha^{m-4}+...+C_2\alpha^2+C_0),$$

said multiplier unit comprising:

a first multiplier circuit (51—65) for performing a multiplication to find $M_1$ in a first step;

a second multiplier circuit (51—65) for performing a multiplication to find $M_2$ in a second step; and an adder circuit (67) for adding the outputs from the first and second multiplier circuits.

**0 096 109**

**Patentansprüche**

1. Fehlerkorrektursystem, das Doppelkorrektur-BCH-Codes empfängt, von denen jeder M Datensymbole und vier Paritätssymbole aufweist, je enthaltend m Bits und dargestellt durch folgendes Erzeugerpolynom:

$$g_{(x)}=(x+1)(x+\alpha)(x+\alpha^2)(x+\alpha^3),$$

wobei $\alpha$ das Ursprungselement des Galoisfeldes GF $(2^m)$ ist und das System die Wurzeln des folgenden Fehlerortpolynoms findet

$$f_{(x)}=x^2+\sigma_1 x+\sigma_2,$$

und dadurch Fehler in den Doppelkorrketur-BCH-Codes korrigiert, umfassend
eine Einrichtung zur Speicherung der Doppelkorrektur-BCH-Codes,
eine Syndromerzeugereinrichtung (41) zum Erzeugen von vier Syndromen $S_0$, $S_1$, $S_2$ und $S_3$ aus den Doppelkorrektur-BCH-Codes,
eine Fehlerortberechnungseinrichtung (401), umfassend
einen ersten Multiplizier/Addierabschnitt (44) zum Multiplizieren und Addieren der vier Syndrome $S_0$, $S_1$, $S_2$ und $S_3$ zur Erhalt von drei Parametern $S_a$, $S_b$ und $S_c$, die gegeben sind durch

$$S_a=S_1{}^2+S_0\ S_2,$$

$$S_b=S_0\ S_3+S_1\ S_2,$$

$$S_c=S_1\ S_3+S_2{}^2,$$

einen zweiten Multiplizier/Addierabschnitt (47A-C, 48A-B) zur Durchführung von Multiplikation und Addition unter sukzessiver Ersetzung von $\alpha^0$ bis $\alpha^{M+3}$ für x in dem folgendem durch Transformation des Fehlerortpolynoms $f_{(x)}$ erhaltenen Polynom

$$f'_{(x)}=S_a f_{(x)}=S_a X_2+S_b x+S_c,$$

wodurch zwei Produkte $S_a\cdot\alpha^2$ und $S_b\cdot\alpha$ und die Summe $S_a\alpha^2+S_b\alpha+S_c$ erhalten werden unter Ausnutzung der Tatsache, daß die Koeffizienten $\sigma_1$, $\sigma_2$ des Fehlerortpolynoms $f_{(x)}$ und die drei Syndrome $S_a$, $S_b$ und $S_c$ aufgrund der Theorie über die Korrktur der Doppelkorrektur-BCH-Codes in folgenden Beziehungen stehen

$$\sigma_1=S_b/S_a=\alpha^i+\alpha^j,$$

$$\sigma^2=S_c/S_a=\alpha^i\ \alpha^j,$$

einen $\alpha^i$, $\alpha^j$ Erfassungsabschnitt (49) zum Erfassen von $\alpha^i$ und $\alpha^j$, die $f'_{(x)}=0$ erfüllen, während der sukzessiven Ersetzungen für x, und
einen dritten Multiplizier/Addierabschnitt (44) zum Addieren von $\alpha^i$ und $\alpha^j$ und Multiplizieren von $\alpha^i$ mit $\alpha^j$, wodurch die Koeffizienten $\sigma_1$, $\sigma_2$ gefunden werden, die die Fehlerorte kennzeichnen,
eine Fehlermusterberechnungseinrichtung umfassend
eine vierte Multiplizier/Addiereinrichtung (44) zum Erhalt eines Fehlermusters $e_i$ aus $\alpha^i$ und $\alpha^j$ aufgrund der folgenden Multiplikation

$$e_i=(S_0\alpha^j+S_1)(\alpha^i+\alpha^j)^{-1},$$

wobei diese Gleichung aus der folgenden Division abgeleitet wurde

$$e_i=\frac{S_0\ \alpha^j+S_1}{\alpha^i+\alpha^j},$$

und zum Erhalt eines weiteren Fehlermusters $e_j$ durch Ausführung der folgendenen Addition

$$e_j=S_0+e_i,\ \text{und}$$

eine Korrektureinrichtung zur Korrektur der Fehler in den Doppelkorrekturcodes, die in der Codespeichereinrichtung gespeichert sind, nach Maßgabe der Koeffizienten $\sigma_1$, $\sigma_2$ und der Fehlermuster $e_i$, $e_j$, wobei der vierte Multiplizier/Addierabschnitt eine Einrichtung zur Ermittlung einer Reziprokkomponente

16

$(\alpha^i+\alpha^j)^{-1}$ enthält, die zum Erhalt des Fehlermusters $e_i$ benutzt wird und durch folgende Gleichung gegeben ist

$$(\alpha^i+\alpha^j)^{-1}=Sa \cdot \alpha^q \cdot \alpha^{-(M+4)z},$$

wobei $\alpha^q$ der Wert für x ist,

$$\text{der } Sa(\alpha^i+\alpha^j)x=Sb \cdot x=\alpha^{(M+4)z} \text{ erfüllt,}$$

wenn sukzessive x durch die Werte $\alpha^0$ bis $\alpha^{M+3}$ ersetzt wird, und wobei z einen der Werte 0, 1,...(l-1) annehmen kann und l die nächsthöhere ganze Zahl von $(2^m-1)/(M+4)$ ist, und wobei diese Einrichtung umfaßt:

eine Tabelleneinrichtung (50) mit l Einträgen, von denen jeder Eintrag für einen Wert $\alpha^{(M+4)z}$ den Reziprokwert $\alpha^{-(M+4)z}$ angibt,

eine Auffangschaltungseinrichtung (46G, 46H) zum Auffangen von $\alpha^{-(M+4)z}$, das in der Tabelleneinrichtung gespeichert ist entsprechend dem Eintrag der Tabelle, wobei $\alpha^{(M+4)z}$ mit $S_b\alpha$ übereinstimmt, das sukzessive von dem zweiten Multiplizier/Addierabschnitt ausgegeben wird, wenn x durch $\alpha^0$ bis $\alpha^{M+3}$ ersetzt wird, und zum Auffangen des zu diesem Zeitpunkt von x angenommenen Werts als Daten $\alpha^q$, und

eine Multipliziereinrichtung (44) zum Multiplizieren von $\alpha^{-(M+4)z}$, $S_a$ und $\alpha^q$.

2. Fehlerkorrektursystem nach Anspruch 1, bei dem der erste, der dritte und der vierte Multiplizier/Addierabschnitt von einem Abschnitt (44) gebildet werden.

3. Fehlerkorrektursystem nach Anspruch 1, bei dem der erste, der dritte und der vierte Multiplizier/Addierabschnitt (44) je eine Multipliziereinheit enthalten, die die nachfolgende Multiplikation ausführt:

$$B(\alpha) \cdot C(\alpha)=M_1+M_2,$$

wobei

$$B(\alpha)=b_{m-1}\alpha^{m-1}+b_{m-2}\alpha^{m-2}+\ldots+b_0$$

$$C(\alpha)=C_{m-1}\alpha^{m-1}+C_{m-2}\alpha^{m-2}+\ldots+C_0,$$

vorausgesetzt daß

$$M_1=\{\alpha B(\alpha)\}(C_{m-1}\alpha^{m-2}+C_{m-3}\alpha^{m-4}+\ldots+C_3\alpha^2+C_1),$$

$$M_2=B(\alpha)(C_{m-2}\alpha^{m-2}+C_{m-4}\alpha^{m-4}+\ldots+C_2\alpha^2+C_0),$$

wobei die Multipliziereinheit umfaßt:

eine erste Multiplizierschaltung (51—65) zur Durchführung einer Multiplikation zur Ermittlung von $M_1$ in einen ersten Schritt,

eine zweite Multiplizierschaltung (51—65) zur Durchführung einer Multiplikation zur Ermittlung von $M_2$ in einen zweiten Schritt, und

eine Addierschaltung (67) zum Addieren der Ausgaben von der ersten und der zweiten Multiplizierschaltung.

**Revendications**

1. Système de correction d'erreurs qui reçoit des codes BCH de correction double constitués chacun de M symboles de données et de quatre symboles de parité, chacun d'eux étant constitué de *m* bits et étant représenté par le polynôme générateur suivant:

$$g_{(x)}=(x+1)(x+\alpha)(x+\alpha^2)(x+\alpha^3),$$

où $\alpha$ est l'élément d'origine d'un champ de Galois $GF(2^m)$, lequel système trouve les racines du polynôme de localisation d'erreur suivant:

$$f_{(x)}=x^2+\sigma_1 x+\sigma_2,$$

de manière à corriger les erreurs existant dans les codes BCH de correction double, ledit système comprenant:

un moyen servant à emmagasiner les codes BCH de correction double;

un moyen (41) générateur de syndromes servant à produire quatre syndromes $S_0$, $S_1$, $S_2$ et $S_3$ à partir des codes BCH de correction double;

un moyen (401) de calcul de localisation d'erreur comprenant:

une première section de multiplication (44) servant à multiplier et additionner les quatre syndromes $S_0$, $S_1$, $S_2$ et $S_3$ afin d'obtenir trois paramètres $S_a$, $S_b$ et $S_c$ qui sont données par les équations suivantes:

$$S_a = S_1^2 + S_0\, S_2,$$

$$S_b = S_0\, S_3 + S_1\, S_2,$$

$$S_c = S_1\, S_3 + S_2,$$

une deuxième section de multiplication-addition (47A-C, 48A-B) servant à effectuer des multiplications et des additions tout en remplaçant $x$ successivement par $\alpha^0, \ldots, \alpha^{M+3}$ dans le polynôme suivant, qui est obtenu par transformation dudit polynôme de localisation d'erreur $f_{(x)}$:

$$f'_{(x)} = S_a f_{(x)} = S_a x^2 + S_b x + S_c,$$

de manière à obtenir deux produits $S_a \cdot \alpha^2$ et $S_b \cdot \alpha$ et une somme $S_a \cdot \alpha^2 + S_b \cdot \alpha + S_c$, en utilisant le fait que les coefficients $\sigma_1$, $\sigma_2$ dudit polynôme de localisation d'erreur $f_{(x)}$ et les trois syndromes $S_a$, $S_b$ et $S_c$ présentent les relations suivantes suivant la théorie de la correction desdits codes BCH de correction double:

$$\sigma_1 = S_b/S_a = \alpha^i + \alpha^j,$$

$$\sigma_2 = S_c/S_a = \alpha^i\, \alpha^j,$$

une section (49) de détection de $\alpha^i$, $\alpha^j$ servant à détecter $\alpha^i$ et $\alpha^j$ qui satisfont $f'_{(x)} = 0$ pendant les remplacements successifs de $x$, et une troisième section (44) de multiplication-addition servant à additionner $\alpha^i$ et $\alpha^j$ et à multiplier $\alpha^i$ par $\alpha^j$, de manière à trouver les coefficients $\sigma_1$, $\sigma_2$ qui définissent les emplacements des erreurs;

un moyen de calcul de configuration d'erreur comprenant un quatrième moyen (44) de multiplication-addition servant à obtenir une configuration d'erreur $e_i$ à partir de $\alpha^i$ et $\alpha^j$ en effectuant la multiplication suivante:

$$e_i = (S_0 \alpha^j + S_1)(\alpha^i + \alpha^j)^{-1},$$

ladite équation ayant été obtenue à partir de la division suivante:

$$e_i = \frac{S_0\, \alpha^j + S_1}{\alpha^i + \alpha^j},$$

et servant à obtenir une autre configuration d'erreur $e_j$ en effectuant l'additoin suivante:

$$e_j = S_0 + e_i;$$

et un moyen de correction servant à corriger les erreurs existant dans lesdits codes de correction double emmagasinés par ledit moyen d'emmagasinage de codes en fonction des coefficients $\sigma_1$, $\sigma_2$ et des configurations d'erreur $e_i$, $e_j$,

où ladite quatrième section de multiplication-addition comporte un moyen servant à trouver la composante inverse $(\alpha^i + \alpha^j)^{-1}$ qui est utilisée pour obtenir la configuration d'erreur $e_i$ et qui est donnée par l'équation suivante:

$$(\alpha^i + \alpha^j)^{-1} = S_a \cdot \alpha^q \cdot \alpha^{-(M+4)z},$$

où $\alpha^q$ est la valeur de $x$ qui satisfait

$$S_a(\alpha^i + \alpha^j)x = S_b \cdot x = \alpha^{(M+4)z},$$

lorsqu'on remplace $x$ par les valeurs successives $\alpha^0$ à $\alpha^{M+3}$ et où $z$ peut prendre l'une des valeurs $0, 1, \ldots$, $(l-1)$, pour lesquelles $l$ est l'entier supérieur le plus proche de $(2^m - 1)/(M+4)$, ledit moyen comprenant:

une table (50) possédant $l$ entrées, chaque entrée donnant, pour une valeur $\alpha^{(M+4)z}$, la valeur inverse $\alpha^{-(M+4)z}$;

un circuit de verrouillage (46G, 46H) servant à verrouiller la valeur $\alpha^{-(M+4)z}$ emmagasinée dans ladite table qui correspond à l'entrée de la table où $\alpha^{(M+4)z}$ coïncide avec $S_b\alpha$, qui est successivement délivré par ladite deuxième section de multiplication-addition lorsqu'on remplace $x$ par $\alpha^0, \ldots, \alpha^{M+3}$, et à verrouiller à cet instant la valeur prise par $x$ sous la forme de la donnée $\alpha^q$; et

un moyen de multiplication (44) servant à multiplier $\alpha^{-(M+4)z}$, $S_a$ et $\alpha^q$.

2. Système de correction d'erreurs selon la revendication 1, où lesdites première, troisième et quatrième sections de multiplication-addition sont formées d'une seule section (44).

**0 096 109**

3. Système de correction d'erreurs selon la revendication 1, où lesdites première, troisième et quatrième sections de multiplication-addition (44) comprennent chacune une unité de multiplicateur qui effectue les multiplications suivantes:

$$B(a) \cdot C(a) = M_1 + M_2,$$

où:

$$B(a) = b_{m-1}a^{m-1} + b_{m-2}a^{m-2} + \ldots + b_0,$$

$$C(a) = C_{m-1}a^{m-1} + C_{m-2}a^{m-2} + \ldots + C_0,$$

dans la mesure où:

$$M_1 = \{aB(a)\}(C_{m-1}a^{m-2} + C_{m-3}a^{m-4} + \ldots + C_3a^2 + C_1),$$

$$M_2 = B(a)(C_{m-2}a^{m-2} + C_{m-4}a^{m-4} + \ldots + C_2a^2 + C_0),$$

ladite unité de multiplicateur comprenant:

un premier circuit multiplicateur (51—65) servant à effectuer une multiplication pour trouver $M_1$ au cours d'une première étape;

un deuxième multiplicateur (51—65) servant à effectuer une multiplication pour trouver $M_2$ au cours d'une deuxième étape; et

un circuit additionneur (67) servant à additionner les signaux de sortie des premier et deuxième circuits multiplicateurs.

19

0 096 109

# F I G. 1

( PRIOR ART )

# F I G.  2

(PRIOR ART)

FIG. 3

FIG. 4

0 096 109

F I G. 5

# FIG. 6

FIG. 7

(a) CP1 |—2 CLOCK—|

(b) CP2

(c) B(α)    B1(α)    B2(α)

(d) C(α)    C1(α)    C2(α)

(e) LP1

(f) H/L    H    L    H    L    H    L

(g) LP2

(h)    B1(α)·C1(α)    B2(α)·C2(α)

(i) LP3

(j) LAT4    B1(α)·C1(α)    B2(α)·C2(α)

FIG. 8

EX-OR41～EX-OR43

E7 ——————— F7
E6 ——————— F6
E5 ——————— F5
E4 ——————— F4
E3 ——⊕—— F3
E2 ——⊕—— F2
E1 ——⊕—— F1
E0 ——————— F0

FIG. 9

EX-OR51～EX-OR55

E7 ——————— H7
E6 ——————— H6
E5 ——————— H5
E4 ——————— H4
E3 ——⊕—— H3
E2 ——⊕—— H2
E1 ——⊕—— H1
E0 ——⊕—— H0

0 096 109